# EUROPEAN PATENT SPECIFICATION

(11) **EP 1 819 507 B1**
(45) Date of publication and mention of the grant of the patent: **27.03.2013**
(21) Application number: 05804297.9
(22) Date of filing: 21.11.2005
(51) Int. Cl.: C23C 28/00, C23C 30/00, C23C 14/00, H01M 8/00, H01M 8/02

(54) **FUEL CELL COMPONENT COMPRISING A COMPLEX OXIDE FORMING COATING**
BRENNSTOFFZELLENKOMPONENTE MIT EINER EIN KOMPLEXES OXID BILDENDEN BESCHICHTUNG
COMPOSANT POUR PILE A COMBUSTIBLE COMPRENANT UN REVETEMENT FORMANT UN OXYDE COMPLEXE

(30) Priority: 30.11.2004 SE 0402935
(43) Date of publication of application: 22.08.2007
(73) Proprietor: Sandvik Intellectual Property AB, 811 81 Sandviken (SE); Topsoe Fuel Cell A/S, 2800 Kongens Lyngby (DK)
(72) Inventor: SCHUISKY, Mikael, S-811 34 Sandviken (SE); PETERSEN, Finn, DK-4000 Roskilde (DK); CHRISTIANSEN, Niels, DK-2820 Gentofte (DK); GUTZON LARSEN, Joergen, DK-2880 Bagsvaerd (DK); LINDEROTH, Soeren, DK-4000 Roskilde (DK); MIKKELSEN, Lars, DK-4000 Roskilde (DK)
(86) International application number: PCT/SE2005/001748
(87) International publication number: WO 2006/059943

(56) References cited:
- DE-A1- 10 306 647
- DE-A1- 10 306 649
- DE-A1- 19 547 699
- GB-A- 2 007 712
- US-A- 6 054 231
- US-A- 6 054 231
- US-A1- 2002 094 465
- US-A1- 2002 132 142

## Description

The present disclosure relates to a fuel cell component, especially for use at high temperatures and in corrosive environments. The fuel cell component consists of a stainless steel, substrate and a coating, which in turn comprises at least one metallic layer and one reactive layer. The fuel cell component is produced by depositing the different layers and thereafter oxidising the coating to accomplish a conductive surface layer comprising at least one complex metal oxide such as a perovskite and/or a spinel.

### Background and prior art

One example of a fuel cell component, which is used at high temperatures and in a corrosive environment, is an interconnect for fuel cells, especially for Solid Oxide Fuel Cells (SOFC). The interconnect material used in fuel cells should work as both separator plate between the fuel side and the oxygen/air side, and current collector of the fuel cell. For an interconnect material to be a good separator plate the material has to be dense to avoid gas diffusion through the material and in order to be a good current collector the interconnect material has to be electrically conducting and should not form insulating oxide scales on its surfaces:

Interconnects can be made of for example graphite; ceramics or metals, often stainless steel. For instance, ferritic chromium steels are used as interconnect material in SOFC, which the two following articles are examples of: "Evaluation of Ferrite Stainless Steels as Interconnects in SOFC Stacks" by P.B. Friehling and S. Linderoth in the Proceedings Fifth European Solid Oxide Fuel Cell Forum, Lucerne, Switzerland, edited by J. Huijsmans (2002) p. 855; "Development of Ferritic Fe-Cr Alloy for SOFC separator" by T. Uehara, T. Ohno & A. Toji in the Proceedings Fifth European Solid Oxide Fuel Cell Forum, Lucerne, Switzerland, edited by J. Huijsmans (2002) p. 281.

In a SOFC application the thermal expansion of the interconnect material must not deviate greatly from the thermal expansion of the electro-active ceramic materials used as anode, electrolyte and cathode in the fuel cell stack. Ferritic chromium steels are highly suitable materials for this application, since the thermal expansion coefficients (TEC) of ferritic steels are close to the TECs of the electro-active ceramic materials used in the fuel cell.

An interconnect in a fuel cell will be exposed to oxidation during operation. Especially in the case of SOFC, this oxidation may be detrimental for the fuel cell efficiency and the lifetime of the fuel cell. For example, the oxide scale formed on the surface of the interconnect material may grow thick and may even flake off or crack due to thermal cycling. Therefore, the oxide scale should have a good adhesion to the interconnect material. Furthermore, the formed oxide scale should also have good electrical conductivity and not grow too thick, since thicker oxide scales will lead to an increased internal resistance. The formed oxide scale should also be chemically resistant to the gases used as fuels in a SOFC, i.e., no volatile metal-containing species such as chromium oxyhydroxides should be formed. Volatile compounds such as chromium oxyhydroxide will contaminate the electro-active ceramic materials in a SOFC stack, which in turn will lead to a decrease in the efficiency of the fuel cell. Furthermore, in the case the interconnect is made out of stainless steel, there is a risk for chromium depletion of the steel during the lifetime of the fuel cell due to diffusion of chromium from the centre of the steel to the formed chromium oxide scale at the surface.

One disadvantage with the use of commercial ferritic chromium steel as interconnect in SOFC is that they usually are alloyed with small amounts of aluminium and/or silicon, which will form Al₂O₃ and SiO₂, respectively, at the working temperature of the SOFC. These oxides are insulating, thereby leading to an increase of electrical resistance of the cell, and as a consequence thereof decreasing the efficiency of the fuel cell.

One solution to the problems that arise when using ferritic steels as interconnect material for SOFC is the use of ferritic steels with very low amounts of Si and Al in order to avoid the formation of insulating oxide layers. These steels are usually also alloyed with manganese and rare earth metals such as La. This has for instance been done in patent application US 2003/0059335, where the steel is alloyed (by weight) with Mn 0.2 -1.0%, La 0.01- 0.4%, Al less than 0.2% and Si less than 0.2%. Another example is in patent application EP 1 298 228 A2 where the steel is alloyed (by weight) with Mn less 1.0%, Si less 1.0%, Al less 1.0%, along with Y less 0.5%, and/or rare earth metals (REM) less 0.2%.

In patent application US 6 054231 a super alloy, defined as an austenitic stainless steel, an alloy of nickel and chromium, a nickel based alloy or a cobalt based alloy, is first coated with either Mn, Mg or Zn and then with a thick layer, 25 to 125 µm of an additional metal from the group Cu, Fe, Ni, Ag, Au, Pt, Pd, Ir or Rh. The coating of a thick second layer of an expensive metal such as Ni, Ag or Au is not a cost productive way of protecting already relatively expensive base materials such as super alloys.

US2004/0058205 describes metal alloys, used as electrical contacts, which when oxidised forms a highly conductive surface. These alloys can be applied onto a substrate, such as steel. The conducting surface is accomplished by doping of one metal, such as Ti, with another metal; such as Nb or Ta. Furthermore, the alloys according to US2004/0058205 are applied onto the surface in one step and thereafter oxidised.

Moreover, a bipolar plate is disclosed in DE 195 47 699 A1 having a part of the surface coated with metal or metal oxide which forms a mixed oxide layer of high conductivity with Cr from the substrate. The invention in DE 195 47 699 A1 also relates to a plate consisting of a chromium oxide forming alloy with cobalt, nickel or iron enrichment layers in the region of the electrode contact surface. Furthermore, in DE 103 06 649 A1 is disclosed a Cr-oxide forming substrate, to be used as interconnect in a SOFC, having a layer comprising an element which may form a spinel.

In DE 103 06 647 A1 the deposition of a complex mixed oxide based on Co_{3-x-y.} CoₓMn_{y}O₄ is disclosed. In this cause the coating is formed by mixing the individual metal oxides and depositing them. None of the cited prior art provides a satisfactory fuel cell component material for use in corrosive environments and/or at high temperatures which is produced in a cost-effective manner and with a high possibility of controlling the quality of the conductive surface.

Therefore, it is a primary object to provide a fuel cell component material with a low surface resistance and high corrosion resistance.

Another object is to provide a fuel cell component material, which will maintain its properties during operation for long service lives.

A further object is to provide fuel cell component material that has a good mechanical strength even at high temperatures.

Another object is to provide a cost-effective material for fuel cell components.

### Summary

A strip substrate of stainless steel, preferably a ferritic chromium steel, is provided with a coating comprising at least one layer of a metallic material and at least one reactive layer. In this context a reactive layer is considered to mean a layer, which consists of at least one element or compound which forms at least one complex metal oxide, such as a spinel and/or a perovskite, with the metallic material of the first layer when oxidised.

The strip substrate may be provided with a coating by any method resulting in a dense and adherent coating. One preferred example of a coating method is vapour deposition, such as PVD, in a continuous roll-to-roll process. Thereafter, fuel cell components are formed of the coated strip by any conventional forming method, such as punching, stamping or the like. The fuel cell component, consisting of a coated strip, may be oxidised before assembling the fuel cell or fuel cell stack, or may be oxidised during operation.

### Brief description of the drawings

Figure 1 GDOES analysis of a 1.5 µm thick CrM oxide.
Figure 2 GIXRD diffractogram of oxidised samples with and without coating.
Figure 3 GIXRD diffractogram of pre-oxidised samples with and without reactive layer

### Detailed description

In the present disclosure the words "providing" and "provided" are to be considered meaning an intentional act and the result of an intentional act, respectively. Consequently, in this context a surface provided with a layer is intended to be a result of an active action.

It has now been discovered that a complex metal oxide structure can be formed on the surface instead of a "traditional" oxide on metal substrates used as fuel cell components. The purpose of the complex oxide is to accomplish a surface with high electrical conductivity in order to have a surface with a low contact resistance.

In this context a complex metal oxide is any metal oxide consisting of, but not limited to, include at least two different metal ions in the structure. Examples of such oxide structures are spinel and perovskite type structures.

A coated strip material is produced by providing a stainless steel substrate, preferably a ferritic chromium steel with a chromium content of 15-30 % by weight. The strip material substrate is thereafter provided with a coating consisting of at least two separate layers. One layer is a metallic layer based on a metal or metal alloy selected from the group consisting of Cr, Co, Mo or alloys based on any one of these elements. In this context "based on" means that the element/alloy constitutes the main component of the composition, preferably constitutes at least 50 % by weight of the composition. The other layer is a reactive layer consisting of at least one element or compound, which forms a complex metal oxide structure with the element/elements of the metallic layer when oxidised. The precise composition of the coating can be tailor-made to achieve the formation of the wanted complex metal oxide structure which could be a spinel, perovskite and/or any other ternary or quartery metal oxide upon oxidisation with the desired properties, for example good conductivity and good corrosion resistance.

One reason for providing the surface with a coating comprising two separate layers, one being the metallic layer and the other being the reactive layer, is that a much more simplified production of the fuel cell component is accomplished. However, the main reason for by providing a coating with two separate layers is that it is easier to control the amount of the different elements in the mixed oxide, i.e. tailor make the desired composition in order to achieve the desired result. Furthermore, an excellent adhesion of the coating to the substrate can be accomplished, thereby improving the properties of fuel cell component and improving the efficiency and prolonging life time of the fuel cell and the fuel cell stack.

The reactive layer may be located on either side of the layer of a metallic material; i.e. sandwiched between the substrate and the metallic layer or, on top of the first deposited metallic layer.

According to one preferred embodiment, the metallic material consists of essentially pure Cr or a Cr-based alloy. In this case, when the coating is oxidised a compound with a formula of MCrO₃ and/or MCr₂O₄ is formed, wherein M is any of the previously mentioned elements/compounds from the reactive layer. The reactive layer may consist of any of the following elements: La, Y, Ce, Bi, Sr, Ba, Ca, Mg, Mn, Co, Ni, Fe or mixtures thereof, more preferably La, Y, Sr, Mn, Co and or mixtures thereof. One specific example of this embodiment is one layer of Cr and the other layer being Co.

The reactive layer is obtained by preoxidation of the surface of the metallic base material according to another preferred embodiment. In the case the metallic base material is a stainless steel, a chromium oxide will be formed. Thereafter a layer of Ni or Co is deposited on the formed oxide according to this preferred embodiment.

The coating may also comprise further layers. For example, the coating may comprise a first metallic layer, thereafter a reactive layer and finally another metallic layer. This embodiment will further ensure a good conductivity of the surface of the fuel cell component. However, due to economical reasons the coating does not comprise more than separate 10 layers, preferably not more than 5 separate layers.

The thickness of the different layers are less than 1 µm. According to one embodiment the thickness of the reactive layer is less than that of the metallic layer. This is especially important when the reactive layer comprises elements or compounds that upon oxidation themselves form non-conducting oxides. In this case it is important that essentially the whole reactive layer/layers are allowed to react and/or diffuse into the metallic layer at least during operation of the fuel cell, so that the conductivity of the component during operation is not affected negatively.

The coated strip may be produced in a batch like process. However, for economical reasons, the strip may be produced-in a continuous roll-to-roll process. The coating may be provided onto the substrate by coating with the metallic layer and the reactive layer. However, according to an alternative embodiment of the invention the coating may also be provided by pre-oxidation of the substrate to an oxide thickness of at least 50 nm and thereafter coating with the additional layer. The coating is thereafter oxidised further as to achieve the complex metal oxide structure. This alternative embodiment of providing the coating onto the base material is especially applicable when the base material is a ferritic chromium steel, such as the oxide formed on the surface is a chromium based oxide.

The coating may be performed with any coating process that generates a thin dense coating with good adhesion to the underlying material, i.e. the substrate or an underlying coating layer. Naturally, the surface of the strip has to be cleaned in a proper way before coating, for example to remove oil residues and/or the native oxide layer of the substrate. According to one preferred embodiment, the coating is performed by the usage of PVD technique in a continuous roll-to-roll process, preferably electron beam evaporation which might be reactive of plasma activated if needed.

Furthermore, the strip may be provided with a coating on one side or on both sides. In the case the coating is provided on both surfaces of the strip, the composition of the different layers on each side of the strip may be the same but may also differ. The strip may be coated on both sides simultaneously or one side at a time.

Optionally, the coated strip is exposed to an intermediate homogenisation step as to mix the separate layers and accomplish a homogenous coating. The homogenisation can be achieved by any conventional heat treatment under appropriate atmosphere, which could be vacuum or a reducing atmosphere, such as hydrogen or mixtures of hydrogen gas and inert gas, such as nitrogen, argon or helium.

The coated strip is thereafter oxidised at a temperature above room temperature, preferably above 100 °C, more preferably above 300 °C, so that a complex metal oxide is formed on the surface of the strip. Naturally, the coating thickness will increase when the coating is oxidised due to the complex metal oxide formation. The oxidation may result in a total oxidation of the coating or a partially oxidation of the coating, depending on for example the thickness of the layers, if the coating is homogenised, and time and temperature of the oxidation. In either case, the different layers of the coating are allowed to at least partially react and/or diffuse into each other, if this is not done by an intermediate homogenisation step. The oxidation may be performed directly after coating, i.e. before the formation of the fuel cell component final shape, after formation to the shape of the final component, i.e. the manufacturing of the fuel cell component from the coated strip, or after the fuel cell or fuel cell assembly, has been assembled, i.e. during operation.

The purpose of accomplishing a complex metal oxide structure on the surface of the strip is that the formed structure has a much lower electrical resistance compared to traditional oxides of the elements of the metallic layer. This will in turn lead to a lower contact resistance of the fuel cell component and therefore also a better efficiency of fuel cell. For example, the resistivity of Cr₂O₃ at 800°C is about 7800 Ω·cm while the resistivity of for example La_{0.85}Sr_{0.15}CrO₃ is several orders of magnitude lower, namely about 0,01 Ω·cm.

Also, in the case of complex chromium containing ternary oxides such as spinel and perovskites it is believe that these oxides are much less volatile than pure Cr₂O₃ at high temperatures.

Furthermore, by providing a complex metal oxide structure, such as perovskite and/or spinel, on the surface of a substrate such as stainless steel the fuel cell component will have good mechanical strength and is less expensive to manufacture than for example fuel cell components made entirely from a complex metal oxide material.

Also, in the case where the substrate is a stainless steel the chromium depletion of the substrate is inhibited since the metallic layer will oxidise long before chromium of the substrate, this is especially pronounced when the metallic layer is Cr or a Cr-based alloy. Therefore, the corrosion resistance of the substrate will not be reduced during operation.

As an alternative to the above-described invention, one might apply the coating by other processes, for example co-evaporation of the different components of the coating.

Examples of the invention will now be described. These should not be seen as limiting of the invention but merely of illustrative nature.

### Example 1

A stainless steel substrate is coated with a coating consisting of a metallic layer and a reactive layer. The metallic layer is a Cr or a Cr-based alloy. The reactive layer in this case includes transition metals, such as Ni, Co, Mn and/or Fe, if the oxide should receive a spinel structure. If a perovskite structure is desired, the reactive layer preferably contains Ba, Sr, Ca, Y, La and/or Ce. Alternatively, Mn and/or REM are allowed to diffuse from the substrate.

The coating is optionally homogenised and thereafter oxidised so as to form the desired structure on the surface. This results in a very low surface resistance of the strip substrate. Also, the Cr-oxides MCrO₃ and/or MCr₂O₄ formed during oxidation are less volatile than pure Cr₂O₃ at high temperatures. This results in a coated strip that is highly suitable to be used as interconnects in Solid Oxide Fuel Cells.

### Example 2

A 0.2 mm thick strip substrate of a ferritic chromium stainless steel was coated. The coating was homogenised so as to achieve a CrM layer wherein M is a mixture of La and Mn. The concentration of Cr in the coating is approximately 35-55 wt%, while the concentration of Mn is approximately 30-60 wt% and the concentration of La is 3-4 wt%.

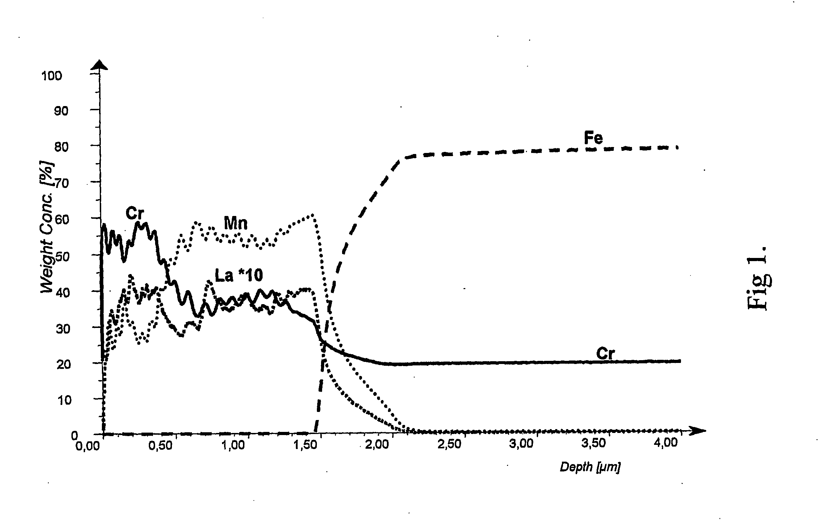

The surface was analysed by Glow Discharge Optical Emission Spectroscopy (GDOES). Using this technique, it is possible to study the chemical composition of the surface layer as a function of the distance from the surface. The method is very sensitive for small differences in concentration and has a depth resolution of a few nanometres. The result of the GDOES analysis of a 1.5 µm thick CrM surface alloying layer is shown in Figure 1.

### Example 3

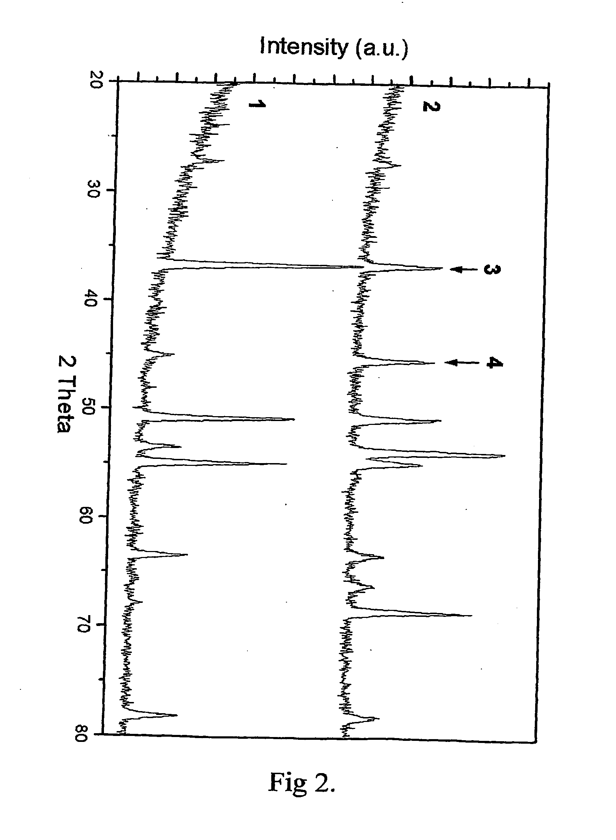

Two samples of a ferritic chromium steel with the nominal composition, by weight max 0.050 % C; max 0.25 % Si; max 0.35 % Mn; 21-23% Cr; max 0,40 % Ni; 0.80-1.2 % Mo; max 0.01 % Al; 0.60 - 0.90 % Nb; small additions of V, Ti and Zr and natural occurring impurities were manufactured. One of the samples was coated with a 0.1 µm thick cobalt layer and a 0.3 µm thick chromium layer. The samples were oxidised in air at 850 °C for 168 hours prior to the analysis. The samples were analysed by Grazing Incidence X-Ray Diffraction (GIXRD) with an incidence angel of 0.5 °, see figure 2. It should be pointed out that GIXRD is a surface sensitive diffraction method and only the crystalline phase of the top layer on the oxidised steel is analysed. Any crystalline phase present under the top layer which is not reached by the grazing X-rays will not be seen in the diffractogram. The amount of spinel vs. chromium oxide formed in the top layer of the oxide scale of each sample were compared by measuring the peak to bottom intensity of the Cr₂O₃ (Eskolaite) reflection at 2 theta = 36.7 ° (3) and diving it by the intensity of the spinel reflection at 2 theta ≈ 45 ° (4). The ratio of Eskolaite /spinel for the uncoated oxidised samples was 9.9 while for the coated sample the ratio was 1.0. This could be interpreted as a tenfold increase of spinel structure in the surface oxide scale formed. In figure 2 the (1) diffractogram is the uncoated sample oxidised in air for 168 hours at 850 °C and the (2) diffractogram is the coated sample oxidised in air for 168 hours at 850 °C.

### Example 4

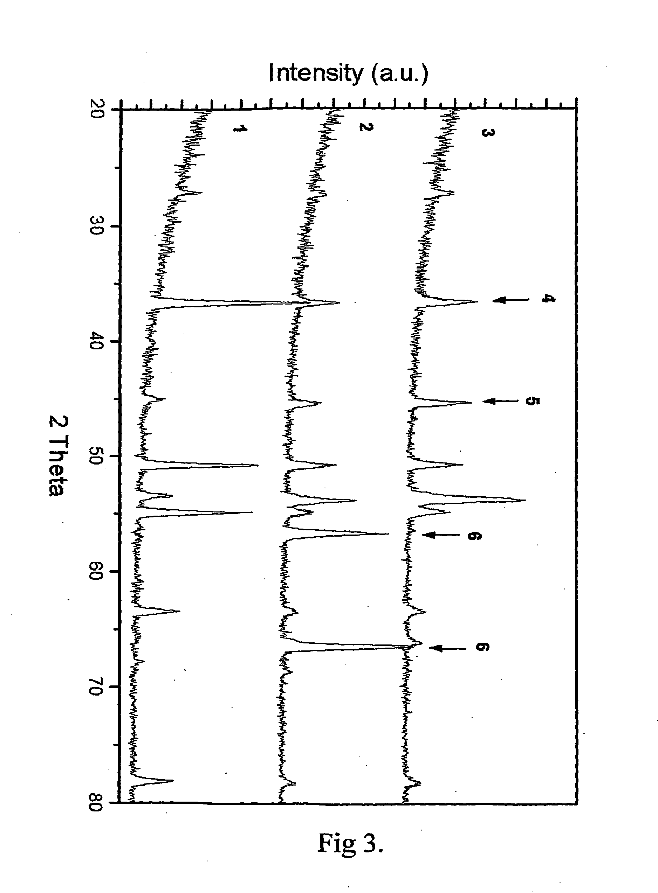

Three samples of a ferritic chromium steel with the nominal composition, by weight max 0.050 % C; max 0.25 % Si; max 0.35 % Mn; 21-23% Cr; max 0,40 % Ni; 0.80-1.2 % Mo; max 0.01 % Al; 0.60 - 0.90 % Nb; small addition of V, Ti and Zr and normally occurring impurities were manufactured. Two of the samples were pre-oxidised in air to get a 100 nm thick oxide scale. The pre-oxidised samples were thereafter coated with a metallic layer. The metallic layer on sample 2 was a 300 nm thick Ni layer and on sample 3 a 300 nm thick Co layer. All three samples were then further oxidised in air at 850 °C for 168 hours prior to the analysis. The samples were analysed by Grazing Incidence X-Ray Diffraction (GDMD) with an incidence angel of 0.5 °, see figure 3. It should be pointed out that GIXRD is a surface sensitive diffraction method and only the crystalline phase of the top layer on the oxidised steel is analysed. Any crystalline phase present under the top layer which is not reached by the grazing X-rays will not be seen in the diffractogram. The amount of spinel vs. chromium oxide formed in the top layer of the oxide scale of each sample were compared by measuring the peak to bottom intensity of the Cr₂O₃(Eskolaite) reflection at 2 theta = 36.7 ° (4) and diving it by the intensity of the spinel MCr₂O₄ reflection at 2 theta ≈ 45 °(5). The ratio of Cr₂O₃ /MCr₂O₄ for the uncoated oxidised samples was 9.9 while for the pre-oxidised sample with the Ni layer the ratio was 1.26 and for the pre-oxidised sample with the Co layer the ratio was 0.98. This indicating an 8.5, respective 10 folded increase of spinel structure in the formed oxide scale. Interesting to note here is that the nickel layer does not only form more spinel oxide in the scale but also NiO is formed when the sample has been oxidised (6). In figure 3 the (1) diffractogram is the uncoated sample oxidised in air for 168 hours at 850 °C, the (2) diffractogram is the pre-oxidised sample with a Ni layer sample oxidised in air for 168 hours at 850 °C and the (3) diffractogram is the pre-oxidised sample with a Co layer sample oxidised in air for 168 hours at 850 °C.

## Claims

1. Fuel cell component consisting of a metallic base material, wherein said base material is stainless steel provided with a coating comprising at least one metallic layer based on a metal selected from the group consisting of Cr, Co, Mo or a metal alloy based on any one of these elements, and at least one reactive layer containing at least one element or compound selected from the group consisting of La, Y, Ce, Bi, Sr, Ba, Ca, Mg, Mn, Co, Ni, Fe and mixtures thereof, which forms at least one complex spinel-containing and/or perovskite-containing mixed oxide with the metal or metal alloy when oxidised, wherein each of the layers is less than 1 µm thick and wherein the reactive layer is sandwiched between the base material and the metallic layer or located on top of the metallic layer, **characterised in that** the stainless steel comprises Mn in an amount of 0.1-5 % by weight and/or rare earth metal/metals in an amount of 0.01-3 % by weight.

2. Fuel cell component according to claim 1 wherein the coating comprises at least two separate metallic layers, preferably based on the same metal or metal alloy, in addition to the reactive layer.

3. Fuel cell component according to any of the preceding claims wherein the reactive layer constitutes a metal or metal alloy other than the metal or metal alloy of the metallic layer.

4. Fuel cell component according to any of the claims 1-3 wherein the base material is coated with a cobalt layer and a chromium layer.

5. Fuel cell component according to any of the claims 1-3, wherein the reactive layer is an oxide obtained by preoxidation of the substrate and the metallic layer is a Co layer.

6. Fuel cell component according to any of the preceding claims being an interconnect for solid oxide fuel cells acting as power and/or heat generating device.

7. Fuel cell component according to any of the preceding claims being an interconnect for solid oxide fuel cells acting as electrolyzing device.

8. Power and/or heat generating device comprising a fuel cell component according to claim 1.

9. Electrolyzing device comprising a fuel cell component according to claim 1.

## Patentansprüche

1. Brennstoffzellenkomponente, bestehend aus einem metallischen Grundmaterial, wobei das Grundmaterial nicht rostender Stahl ist, der mit einer Beschichtung versehen ist, weiche wenigstens eine Metallschicht auf der Grundlage eines Metalls umfasst, welches aus der Gruppe ausgewählt ist, die aus Cr, Co, Mo oder einer Metalllegierung auf der Grundlage von einem beliebigen dieser Elemente besteht, und wenigstens eine reaktive Schicht, welche wenigstens ein Element oder eine Verbindung enthält, das/die aus der Gruppe ausgewählt ist, die aus La, Y, Ce, Bi, Sr. Ba, Ca, Mg, Mn, Co, Ni, Fe und Gemischen davon besteht, das oder die ein komplexes Spinell-enthaltendes und/oder Perowskit-enthaltendes gemischtes Oxid mit dem Metall oder der Metalllegierung bildet, wenn es oxidiert wird, wobei jede dieser Schichten weniger als 1 µm dick ist, und wobei die reaktive Schicht sandwichartig zwischen dem Grundmaterial und der Metallschicht angeordnet ist oder oben auf der Metallschicht angeordnet ist, **dadurch gekennzeichnet, dass** der nicht rostende Stahl Mn In einer Menge von 0,1-5 Gew.-% und/oder ein Seltenerdmetall/Seltenerdmetalle in einer Menge von 0,07-3 Ges.-% umfasst.

2. Brennstoffzellenkomponente nach Anspruch 1, wobei die Beschichtung zusätzlich zu der reaktiven Schicht wenigstens zwei separate Metallschichten umfasst, vorzugsweise auf der Grundlage des gleichen Metalls oder der gleichen Metalllegierung.

3. Brennstoffzellenkomponente nach einem der vorangehenden Ansprüche, wobei die reaktive Schicht ein Metall oder eine Metalllegierung einsetzt, die von dem Metall oder der Metalllegierung der Metallschicht verschieden ist.

4. Brennstoffzellenkomponente nach einem der Ansprüche 1 bis 3, wobei das Grundmaterial mit einer Kobaltschicht und einer Chromschicht beschichtet ist.

5. Brennstoffzellenkomponente nach einem der Ansprüche 1 bis 3, wobei die reaktive Schicht ein Oxid ist, welches erhalten wird durch die Voroxidation des Substrats, und die Metallschicht eine Co-Schicht ist.

6. Brennstoffzellenkomponente nach einem der vorangehenden Ansprüche, welche eine Verbindung für eine Festoxidbrennstoffzelle ist, die als eine Strom- und/oder Wärmeerzeugungsvorrichtung arbeitet.

7. Brennstoffzellenkomponente nach einem der vorangehenden Ansprüche, welche eine Verbindung für eine Festoxidbrennstoffzelle ist, die als eine Elektrolysevorrichtung arbeitet.

8. Strom- und/oder Wärmeerzeugungsvorrichtung, umfassend eine Brennstoffzellenkomponente nach Anspruch 1.

9. Elektrolysevorrichtung, umfassend eine Brennstoffzellenkomponente nach Anspruch 1.

## Revendications

1. Composant pour pile à combustible consistant en un matériau de base métallique, dans lequel ledit matériau de base est de l'acier inoxydable pourvu d'un revêtement comprenant au moins une couche métallique à base d'un métal choisi dans le groupe constitue par Cr, Co, Mo ou d'un alliage métallique à base de l'un quelconque de ces éléments, et d'au moins une couche réactive contenant au moins un élément ou composé choisi dans le groupe constitué par La, Y, Ce, Bi, Sr, Ba, Ca, Mg, Mn, Co, Ni, Fe et leurs mélanges, qui forme avec le métal ou l'alliage métallique lorsque il est oxyde au moins un oxyde mixte contenant un spinelle complexe et/ou contenant un pérovskite, dans lequel chacune des couches présente une épaisseur inférieure à 1µm et dans lequel la couche réactive est disposée en sandwich entre le matériau de base et la couche métallique ou disposée au-dessus de la couche métallique, **caractérisé en ce que** l'acier inoxydable comprend Mn en une quantité de 0,1-5% en poids et/ou un métal/des métaux de terre rare en une quantité de 0,01-3% en poids.

2. Composant pour pile à combustible selon la revendication 1, dans lequel le revêtement comprend en plus de la couche réactive au moins deux couches métalliques distinctes, de préférence basées sur le même métal ou alliage métallique.

3. Composant pour pile à combustible selon l'une quelconque des revendications précédentes, dans lequel la couche réactive constitue un métal ou alliage métallique autre que le métal ou alliage métallique de la couche métallique.

4. Composant pour pile à combustible selon l'une quelconque des revendications 1-3, dans lequel le matériau de base est revêtu d'une couche de cobalt et d'une couche de chrome.

5. Composant pour pile à combustible selon l'une quelconque des revendications 1-3, dans lequel la couche réactive est un oxyde obtenu par pré-oxydation du substrat et la couche métallique est une couche de Co.

6. Composant pour pile à combustible selon l'une quelconque des revendications précédentes, qui est une interconnexion pour piles à combustible à oxyde solide agissant en tant que dispositif de génération de puissance et/ou de génération de chaleur.

7. Composant pour pile à combustible selon l'une quelconque des revendications précédentes, qui est une interconnexion pour piles à combustible à oxyde solide agissant en tant que dispositif d'électrolyse.

8. Dispositif générateur de puissance et/ou de chaleur comprenant un composant pour pile à combustible selon la revendication 1.

9. Dispositif d'électrolyse comprenant un composant pour pile à combustible selon la revendication 1.
